# EUROPÄISCHE PATENTSCHRIFT

(11) **EP 0 607 879 B1**
(45) Veröffentlichungstag und Bekanntmachung des Hinweises auf die Patenterteilung: **09.10.1996**
(21) Anmeldenummer: 94100478.0
(22) Anmeldetag: 14.01.1994
(51) Int. Cl.: H05K 5/00

(54) **Gehäuse für ein elektronisches Gerät**
Casing for a electronic device
Boîtier pour un appareil électronique

(30) Priorität: 20.01.1993 DE 9300661 U
(43) Veröffentlichungstag der Anmeldung: 27.07.1994
(73) Patentinhaber: VDO Adolf Schindling AG, D-60326 Frankfurt/Main (DE)
(72) Erfinder: Hug, Klaus, Dipl.-Ing. (FH), D-78727 Oberndorf (DE)

(56) Entgegenhaltungen:
- DE-A- 3 002 310
- DE-A- 3 712 294
- DE-A- 4 215 041
- DE-U- 7 822 904
- GB-A- 1 079 349
- US-A- 5 023 752

## Beschreibung

Die Erfindung betrifft ein Gehäuse für ein elektronisches Gerät mit einem Rahmen mit rechteckförmigem Querschnitt, einem Deckel, einem Boden und mit innerhalb des Rahmens ausgebildeten Mitteln zur Aufnahme wenigstens einer Leiterplatte.

Ist ein derartiges Gerät für den Einsatz in Kraftfahrzeugen vorgesehen und soll es als Einbaugerät mit nur einer für Betätigungen, für Anzeigen und dergleichen zugänglichen Frontwand oder für die Anbringung in Fahrzeugräumen, in denen es für die Fahrzeuginsassen unsichtbar ist, konzipiert sein, so dominieren weniger ästhetische als funktionale und fertigungstechnische Überlegungen bzw. vorgegebene Einbaubedingungen.

Das gattungsgemäß geschilderte Gehäusekonzept ist, wie aus der DE G 8809912 hervorgeht, insoweit vorteilhaft, als sowohl während der Herstellung des Gerätes als auch für Wartungszwecke eine einfache Zugänglichkeit und Austauschbarkeit einer in dem Rahmen eingebauten Leiterplatte und gegebenenfalls anderer Funktionsgruppen gegeben ist. Das heißt, der aus dem Rahmen und den Funktionsgruppen gebildete und in diesem Zustand an Lager legbare Gerätemodul bleibt bis zur endgültigen kundenspezifischen Fertigstellung des Gerätes prüffähig und umrüstbar. Ferner ist das Gehäuse aus wenigen einfachen Bauteilen zusammengefügt, so daß auch die Voraussetzungen für die Serienfertigung erfüllt sind.

Aufgrund der in Richtung der Rahmenöffnung erfolgenden Verschraubung des Gerätes wird jedoch innerhalb des Rahmens Raum für die Durchführung der Schrauben und für eine versenkte Anordnung der Schrauben benötigt, wenn im letzteren Falle die Verschraubungen flächenbündig erfolgen sollen. Für ein in einen Schacht einzubauendes Gerät, wobei die Öffnung des Schachtes im wesentlichen dem Querschnitt des Geräterahmens in Richtung der Hochachse entspricht, ist diese Ausführungsform wegen der schlechten Nutzung des zur Verfügung stehenden Raumes nicht geeignet.

Es war somit die Aufgabe gestellt, unter Beibehaltung des geschilderten Grundkonzeptes ein Gehäuse für ein elektrisches Gerät zu schaffen, welches eine maximale Nutzung des in einem Einbauschacht gegebenen Raumes bietet, dessen Fertigungsaufwand gegenüber dem beschriebenen Gehäuse weiter reduziert ist und dessen Montage leichter und schneller durchgeführt werden kann.

Die Lösung dieser Aufgabe beschreibt der Anspruch 1. Vorteilhafte Ausgestaltungen der Erfindung stellen die Unteransprüche dar.

Der besondere Vorzug der Erfindung ist darin zu sehen, daß Deckel und Boden als einfachste Bauteile ausgebildet und ebenso leicht, d.h. durch Aufsetzen und Verschieben mit dem Rahmen verbindbar sind, wobei durch eine gewisse Vorspannung, mit anderen Worten durch Ausnützung der Federungsfähigkeit der Zungen, beim Anbringen der Klammer ein Spielausgleich erfolgt. Die erfindungsgemäß vorgesehene Fügeverbindung erfordert, um eine feste Verbindung der Gehäuseteile zu erzielen, lediglich diese eine mit dem Rahmen vorzugsweise rastend verbindbare Klammer. Falls erforderlich, kann die Klammer als Plombe ausgebildet sein. Bei erhöhten Sicherheitsanforderungen ist es zweckmäßig, die Klammer mittels zusätzlich einer Schraube, die ihrerseits plombiert wird, an dem Rahmen zu befestigen. Erwähnenswert ist ferner, daß die Ausbildung von Boden und Deckel als Stahlblechteile, die hinsichtlich der erforderlichen Stabilität relativ dünnwandig ausgebildet sein können, eine maximale Raumnutzung bieten und somit bezüglich des Gehäuseinnenraumes ein Minimum an Bauhöhe erzielbar ist. Ferner kann der Rahmen entweder als Blechrahmen oder, bei ausreichender Stückzahl, als Kunststoffteil ausgebildet sein. Durch die großflächige Abdeckung des Rahmens durch Deckel und Boden und die an Boden und Deckel angeformten Wände ist auch bei Verwendung eines Kunststoffrahmens die bei einer Kfz-Anwendung erforderliche elektromagnetische Schirmung nicht entscheidend beeinträchtigt. Mit der gefundenen Bauform ist nicht nur eine schnelle und unkomplizierte Montage des Gehäuses möglich, sondern in gleicher Weise auch eine Demontage und Aufteilung in die einzelnen Materialkomponenten, d.h. das Gehäuse ist problemlos recyclingfähig.

Im folgenden sei ein Ausführungsbeispiel des erfindungsgemäßen Gehäuses anhand der beigefügten Zeichnungen näher erläutert. Es zeigen
Fig. 1 eine Frontansicht eines als tragendes Gehäusebauteil ausgebildeten Rahmens,
Fig. 2 eine perspektivische Rückansicht des in der erfindungsgemäßen Weise zusammengefügten Gehäuses und einer Frontblende,
Fig. 3 eine Seitenansicht in einem Montagezustand, in dem der Deckel im Zustand des Zusammenfügens mit dem Rahmen dargestellt ist,
Fig. 4 eine Draufsicht des Gehäuses im Bereich einer Eckverschneidung zwischen der Front- und einer Seitenwand,
Fig. 5 einen Teilschnitt des Gehäuses mit einer der Verbindung von Rahmen, Boden und Deckel dienenden Klammer,
Fig. 6 einen Teilschnitt des Gehäuses mit einer mit dem Rahmen verschraubten und plombierten Klammer.

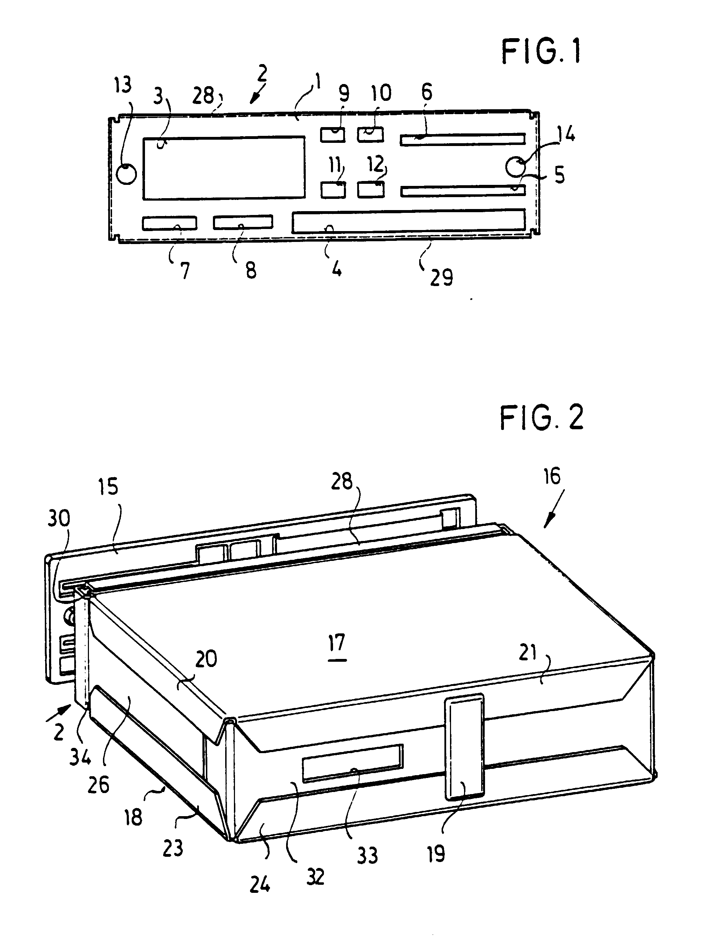

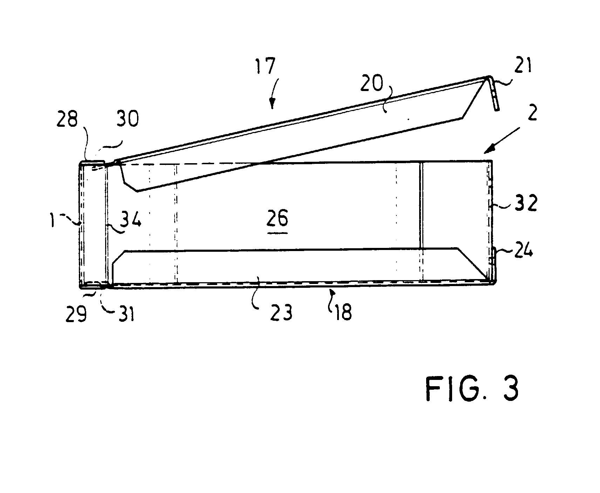

Bei dem dargestellten Ausführungsbeispiel stellt die Fig. 1 die Frontwand bzw. einen Schenkel 1 eines umlaufenden Rahmens 2 eines Gehäuses dar. Mit 3, 4, 5 und 6 sind in dem Schenkel 1 ausgebildete Aussparungen bezeichnet, die beispielsweise für den Einbau einer Anzeigeeinrichtung, als Zugangsöffnung für einen Druckerschacht oder als Einstecköffnungen für die Aufnahmeeinrichtungen von Datenkarten vorgesehen sein können. Weitere Öffnungen 7 und 8 sowie 9, 10 11 und 12 dienen beispielsweise dem Durchgreifen von Stegtasten oder dem Anbringen von Tastenhaltern bzw. Tastenführungen, während mit 13 und 14 Öffnungen bezeichnet sind, welche ein Aufrasten einer das Gerät frontseitig abschließenden Blende 15 (Fig. 2) gestatten.

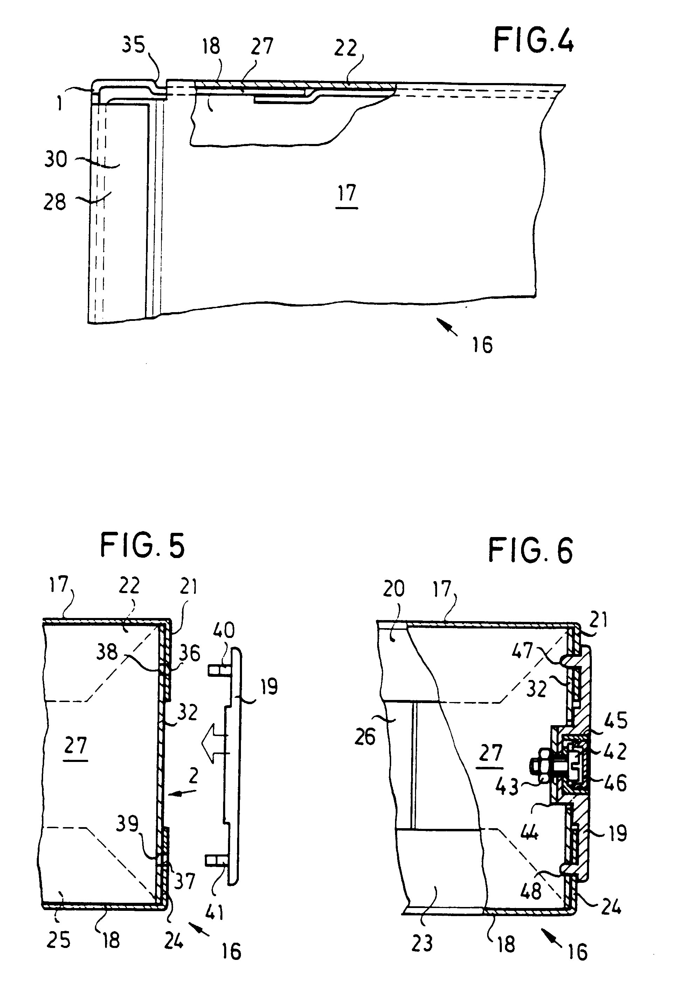

Die Fig. 2 zeigt mit einer rückseitigen perspektivischen Ansicht das komplette Gehäuse 16 bestehend aus dem Rahmen 2, einem Deckel 17, einem Boden 18 und einer Klammer 19. Der Boden 18 und der Deckel 17 sind jeweils als flache Platten ausgebildet und zum Zwecke der elektromagnetischen Schirmung aber auch der optimalen Raumnutzung aus relativ dünnwandigem Stahlblech hergestellt. Dabei sind beide Teile gleichgestaltet und jeweils an drei Seiten mit Wänden 20, 21 und 22 (Fig. 4) bzw. 23, 24 und 25 (Fig. 4) versehen. Die sich gegenüberliegenden Wände 20, 22 und 23, 25 übergreifen, weil der Deckel 17 und der Boden 18 mit dem Rahmen 2 verbunden sind, die jeweiligen Schenkel 26 und 27 (Fig. 5) des Rahmens 2 weitgehend spielfrei. Die jeweils dritte Wand 21 bzw. 24 dient beim Zusammenfügen von Deckel 17, Boden 18 und Rahmen 2 sozusagen als Anschlag.

Wie aus den Figuren ferner ersichtlich ist, ist bei dem dargestellten Ausführungsbeispiel auch der Rahmen 2 aus Stahlblech hergestellt und beispielsweise aus zwei nicht bezeichneten und nicht notwendigerweise gleichschenkligen, U-förmigen Teilen zusammengefügt. Ferner sind an dem frontseitigen Schenkel 1 des Rahmens 2 Leisten 28, 29 angeformt, die in die Rahmenöffnung hineinragen und beim Zusammenfügen des Gehäuses 16 mit dem Boden 18 und dem Deckel 17 in Wirkverbindung treten. Dabei untergreifen jeweils am Deckel 17 und am Boden 18 angeformte Zungen 30 und 31 die Leisten 28 und 29. Für eine spielfreie Verbindung der Gehäuseteile ist es vorteilhaft, diese Fügeverbindung derart auszubilden, daß der Abstand zwischen der Innenfläche von Deckel 17 bzw. Boden 18 und der Außenfläche der jeweiligen Zungen 30 und 31 gleich oder kleiner ist als der Abstand zwischen den Innenflächen der Leisten 28 und 29 und den Stirnflächen der Schenkel 26 und 27, auf denen jeweils der Deckel 17 und der Boden 18 aufliegen. Dadurch wird die Federungsfähigkeit der Zungen in die Fügeverbindung miteinbezogen, d.h. bezüglich der Klammer 19 eine gewisse Vorspannung und somit Spielfreiheit erzielt. Für das Untergreifen der Zungen 30 und 31 unter die Leisten 28 und 29 ist jedoch ein gewisses Schrägeinführen von Deckel 17 und Boden 18 erforderlich, wie es die Fig. 3 beispielsweise zeigt.

Selbstverständlich werden der Deckel 17 und der Boden 18 erst dann mit dem Rahmen 2 verbunden, wenn das Gerät sonst funktionsfertig montiert ist. Durch die an dem rückseitigen Schenkel 32 des Rahmen 2 vorgesehene Öffnung 33 ist dann ein Steckersockel zugänglich.

Der Vollständigkeit halber sei noch erwähnt, daß die Schenkel 26 und 27 des Rahmens 2 im Übergangsbereich zum frontseitigen Schenkel 1 durch eine geeignete Abkröpfung 34 bzw. 35 soweit parallel versetzt sind, daß die Außenflächen der Wände 20, 22 und 23, 25 und die Außenflächen der Übergangsbereiche der Schenkel 26 und 27 im wesentlichen in einer Ebene liegen.

Für das Anbringen der Klammer 19 ist es, wenn der Deckel 17 und der Boden 18 unter einer gewissen Vorspannung mit dem Rahmen 2 verbunden sein sollen, erforderlich, den Deckel 17 und den Boden 18 auf den Rahmen 2 niederzudrücken. Das heißt, die in den Wänden 21 und 24 vorgesehenen Öffnungen 36 und 37 und die im Rahmen 2 übereinander angebrachten Öffnungen 38 und 39 müssen zum Fluchten gebracht werden. Bei der Lösung gemäß Fig. 5 sind die Öffnungen 36, 37, 38 und 39 schlitzförmig ausgebildet. Dementsprechend sind an der Klammer 19 paarweise quer zur Schnittebene federnde Riegel 40 und 41 angeformt. Auf diese Wiese läßt sich in Richtung der Hochachse des Gehäuses 16 eine relativ enge Passung verwirklichen, während quer zur Schnittebene ein beliebig großer Bewegungsfreiraum für die Riegel 40 und 41 geschaffen werden kann. Die Klammer 19 kann gleichzeitig als Plombe dienen, indem eine Sollbruchstelle und/oder beispielsweise ein firmentypischer Schriftzug angebracht wird.

Mit der Fig. 6 ist ein Ausführungsbeispiel dargestellt, bei dem die Klammer 19 mittels einer Schraube 42 an dem Rahmen 2 befestigt ist. Soll, wie dargestellt, die Schraube 42 versenkt angeordnet werden, so ist die Klammer 19 mit einer geeigneten Senkung herzustellen und am Rahmen 2 eine der Klammer 19 entsprechende, mit einer Einpreßmutter 43 versehene Auflage 44 auszuprägen. Wie aus der Fig. 6 ferner hervorgeht, ist mit der Schraube 42 ein Plombennäpfchen 45 befestigt und eine Plombe 46 angebracht. Mit 47 und 48 sind in diesem Falle nicht notwendigerweise federnde Finger bezeichnet, die in geeignete Öffnungen im Rahmen 2 und in den Wänden 21 und 24 von Deckel 17 und Boden 18 spielfrei eingreifen.

## Patentansprüche

1. Gehäuse für ein elektronisches Gerät mit einem Rahmen mit rechteckförmigem Querschnitt, einem Deckel, einem Boden und mit innerhalb des Rahmens ausgebildeten Mitteln zur Aufnahme wenigstens einer Leiterplatte,
dadurch gekennzeichnet,
daß der Boden (18) und der Deckel (17) als flache Platten aus Stahlblech mit an jeweils drei Seiten angeformten Wänden (20, 21, 22 und 23, 24, 25) ausgebildet sind, wobei das Innenmaß zwischen den beiden sich gegenüberliegenden Wänden (20, 22 und 23, 25) im wesentlichen gleich ist dem Außenmaß zweier sich gegenüberliegender Schenkel (26, 27) des Rahmens (2) und
daß an einem die Frontwand des Gehäuses (16) bildenden Schenkel (1) des Rahmens (2) in zwei Ebenen quer zur Öffnung des Rahmens (2) Leisten (28, 29) angeformt sind, welche in die Rahmenöffnung hineinragen,
daß an dem Schenkel (32) des Rahmens (2), welcher dem die Leisten (28, 29) tragenden Schnenkel (1) gegenüberliegt, wenigstens zwei in Richtung der Hochachse des Rahmens (2) übereinanderliegende Öffnungen (38, 39) ausgebildet sind, daß der Boden (18) und der Deckel (17) an der einen Seite derart ausgebildet sind, daß sie beim bestimmungsgemäßen Aufliegen auf dem Rahmen (2) die Leisten (28, 29) untergreifen und an den gegenüberliegenden Wänden (21, 24) vorgesehene Öffnungen (36, 37) mit den im Rahmen (2) befindlichen Öffnungen (38, 39) fluchten und
daß eine Rahmen (2), Boden (18) und Deckel (17) verbindende Klammer (19) vorgesehen ist, an welcher den Öffnungen (36, 37, 38, 39) zugeordnete Finger (40, 41 bzw. 47, 48) ausgebildet sind.

2. Gehäuse nach Anspruch 1,
dadurch gekennzeichnet,
daß die Ansatzpunkte der sich gegenüberliegenden Wände (20, 22 und 23, 25) von der jeweiligen nicht mit einer Wand abschließenden Seite des Deckels (17) bzw. Bodens (18) um ein gewisses Maß abgesetzt sind und die dadurch gegebenen flachen Zungen (30, 31) um die Materialstärke des Rahmens (2) in zur jeweiligen Plattenebene von Deckel (17) und Boden (18) parallelen Ebene abgekröpft sind.

3. Gehäuse nach Anspruch 1,
dadurch gekennzeichnet,
daß an der Klammer (19) den Rahmen (2) hintergreifende federnde Riegel (40, 41) angeformt sind.

4. Gehäuse nach Anspruch 1,
dadurch gekennzeichnet,
daß die Klammer (19) mit einer Schraube (42) am Rahmen (2) befestigbar und die Schraube (42) unter Verwendung eines Plombennäpfchens (45) plombierbar ist.

5. Gehäuse nach Anspruch 1,
dadurch gekennzeichnet,
daß die Plombenfassung unmittelbar in der Klammer (19) ausgebildet ist und in dem Rahmen (2) eine der Klammer (19) entsprechende versenkte Auflage (44) ausgeprägt ist.

6. Gehäuse nach Anspruch 1,
dadurch gekennzeichnet,
daß der Rahmen (2) als ein Teil aus Kunststoff hergestellt ist und daß die Leisten (28, 29) in Form mehrerer wechselweise angeformter Zungen ausgebildet sind.

7. Gehäuse nach Anspruch 1,
dadurch gekennzeichnet,
daß der Rahmen (2) aus zwei im wesentlichen U-förmig ausgebildeten Teilen aus Stahlblech zusammengefügt ist.

## Claims

1. A housing for an electronic device having a frame of rectangular cross-section, a cover, a base and means within the frame for receiving at least one printed circuit board, characterized in that the base (18) and the cover (17) are constructed as flat plates of sheet steel having walls (20, 21, 22 and 23, 24, 25) integrally formed on three sides in each case, the internal dimension between the two mutually opposing walls (20, 22 and 23, 25) being substantially equal to the external dimension of two mutually opposing limbs (26, 27) of the frame (2), and in that ledges (28, 29) are integrally formed on a limb (1) of the frame (2), forming the front wall of the housing (16), in two planes transversely with respect to the opening of the frame (2), and these ledges (28, 29) project into the frame opening, in that at least two openings (38, 39) lying one above the other in the direction of the upright axis of the frame (2) are made on the limb (32) of the frame (2) which is opposite the limb (1) bearing the ledges (28, 29), in that the base (18) and the cover (17) are constructed on the one side such that they reach under the ledges (28, 29) when they lie on the frame (2) in the manner intended, and openings (36, 37) provided on the opposing walls (21, 24) are flush with the openings (38, 39) in the frame (2), and in that a clip (19) connecting the frame (2), the base (18) and the cover (17) and on which fingers (40, 41 and 47, 48) associated with the openings (36, 37, 38, 39) are constructed is provided.

2. A housing according to Claim 1, characterized in that the starting points of the mutually opposing walls (20, 22 and 23, 25) are set back by a certain dimension from the respective side of the cover (17) or base (18) which does not end in a wall, and the flat tabs (30, 31) produced thereby are chamfered by the thickness of material of the frame (2) in the plane parallel to the respective plate plane of the cover (17) and the base (18).

3. A housing according to Claim 1, characterized in that resilient bars (40, 41) reaching behind the frame (2) are integrally formed on the clip (19).

4. A housing according to Claim 1, characterized in that the clip (19) may be secured to the frame (2) by means of the screw (42) and the screw (42) may be lead-sealed, using a lead-seal cup (45).

5. A housing according to Claim 1, characterized in that the lead-seal mounting is constructed directly in the clip (19) and a countersunk bearing surface (44) corresponding to the clip (19) is mounted in embossed manner on the frame (2).

6. A housing according to Claim 1, characterized in that the frame (2) is manufactured as one part of synthetic material, and in that the ledges (28, 29) are constructed in the form of a plurality of alternately integrally formed tabs.

7. A housing according to Claim 1, characterized in that the frame (2) is joined together from two substantially U-shaped parts of sheet steel.

## Revendications

1. Boîtier pour un appareil électronique comprenant un cadre de section rectangulaire, un couvercle, un fond et des moyens, réalisés à l'intérieur du cadre, pour le logement d'au moins une platine à circuits imprimés.
caractérisé par le fait
que le fond (18) et le couvercle (17) sont réalisés en plaques plates et fabriqués en tôle d'acier avec, formées sur respectivement trois côtés, des parois (20, 21, 22 et 23, 24, 25), la dimension intérieure entre les parois opposées (20, 22 et 23, 25) étant, pour l'essentiel, identique à la dimension extérieure de deux ailes opposées (26, 27) du cadre (2) et
que sur l'une des ailes (1) du cadre (2) constituant la paroi frontale du boîtier (16) sont formés des liteaux (28, 29) en deux plans transversalement à l'ouverture dudit cadre (2) qui pénètrent dans l'ouverture de cadre, que sur l'aile (32) du cadre (2), qui est située à l'opposé de l'aile (1) portant les liteaux (28, 29), sont pratiquées au moins deux ouvertures (38, 39) superposées dans le sens de l'axe vertical du cadre (2),
que le fond (18) et le couvercle (17) sont réalisés d'un côté en une forme telle que, lorsque, conformément à l'usage auquel ils sont destinés, ils posent sur le cadre (2), ils passent sous les liteaux (28, 29) et que des ouvertures (36, 37) prévues sur les parois opposées (21, 24) sont alignées avec les ouvertures (38, 39) pratiquées dans le cadre (2) et
qu'il est prévue une bride de fixation (19) servant à l'assemblage du cadre (2), du fond (18) et du couvercle (17), sur laquelle sont formés des doigts (40, 41 ou 47, 48) associés aux ouvertures (36, 37, 38, 39).

2. Boîtier selon la revendication 1,
caractérisé par le fait
que les points de départ des parois opposées (20, 22 et 23, 25) sont décalés d'une certaine dimension de la face respective, ne se terminant pas par une paroi, du couvercle (17) ou du fond (18) et que les languettes plates (30, 31) ainsi données présentent un coude de l'épaisseur de matériau du cadre (2) dans des plans parallèles au plan de plaque respectif du couvercle (17) et du fond (18).

3. Boîtier selon la revendication 1,
caractérisé par le fait
que sur la bride de fixation (19) sont formés des verrous élastiques (40, 41) passant derrière le cadre (2).

4. Boîtier selon la revendication 1,
caractérisé par le fait
que la bride de fixation (19) peut être fixée sur le cadre (2) à l'aide d'une vis (42) et que ladite vis (42) peut être plombée à l'aide d'un godet de plombage (45)

5. Boîtier selon la revendication 1,
caractérisé par le fait
que le logement du plomb est formé directement dans la bride de fixation (19) et que dans le cadre (2) est estampé un support noyé (44) correspondant à la bride de fixation (19).

6. Boîtier selon la revendication 1,
caractérisé par le fait
que le cadre (2) est une pièce fabriquée en matière synthétique et que les liteaux (28, 29) sont réalisés sous forme de plusieurs languettes alternativement moulées dessus.

7. Boîtier selon la revendication 1,
caractérisé par le fait
que le cadre (2) est un assemblage de deux pièces en tôle d'acier présentant, pour l'essentiel, la forme d'un U.
